# EUROPEAN PATENT APPLICATION

(11) **EP 4 832 683 A1**
(43) Date of publication of application: **28.10.2026**
(21) Application number: 26172461.1
(22) Date of filing: 15.04.2026
(51) Int. Cl.: H05K 7/20

(54) **LIQUID COOLING CHANNEL ASSEMBLY AND POWER MODULE USING SAME**

(30) Priority: 22.04.2025 CN 202510507523; 16.09.2025 CN 202511324727
(71) Applicant: Delta Electronics (Thailand) Public Co., Ltd., Samutprakarn 10280 (TH)
(72) Inventor: Wang, Fuxiang, Shanghai, 201209 (CN); Peng, Xu, Shanghai, 201209 (CN); Jiang, Qing, Shanghai, 201209 (CN); Liao, Yongkai, Shanghai, 201209 (CN); Li, Meng, Shanghai, 201209 (CN)
(74) Representative: Uexküll & Stolberg

(57) **Abstract**

A liquid cooling channel assembly (1, 1a, 1b) and a power module (2, 2a, 2b) are disclosed. The liquid cooling channel assembly (1, 1a, 1b) includes a front-end component (10), a curved component (20), and first and second lateral linear flow channel components (30, 40; 30a, 40a). The front-end component (10) has an inlet (11) and an outlet (12) at a connection side (13). The curved component (20) has first and second communication ends (21, 22). The first and second lateral linear flow channel components (30, 40; 30a, 40a) are extended along first and second horizontal directions to communicate the inlet (11) with the first communication end (21) and the outlet (12) with the second communication end (22), respectively. The first and second lateral linear flow channel components are spaced apart to form opposite inner heat dissipation surfaces (31, 41) and outer heat dissipation surfaces (32, 42). A first heat-generating device (91) is thermally connected to the inner heat dissipation surfaces (31, 41), and a second heat-generating device (92, 92a) is thermally connected to at least one of the outer heat dissipation surfaces (32, 42).

## Description

### FIELD OF THE INVENTION

The present disclosure relates to the technical field of power electronics, and more particularly to a liquid cooling channel assembly and a power module using the same for achieving optimized heat dissipation performance of the power module through a flexible modular design.

### BACKGROUND OF THE INVENTION

Liquid cooling solutions are widely adopted to address the heat dissipation challenges of high-power supplies in on-board power products. Conventional liquid cooling assembly structures, such as waterway modules, are typically fabricated using casting or sheet metal processes. The die-casting parts have large manufacturing dimensions and poor precision due to molding process limits. Furthermore, the die-casting parts involve high manufacturing costs. On the other hand, the sheet metal parts have limited structural strength. Therefore, the sheet metal parts cannot effectively meet waterway sealing pressure requirements and deform easily.

On the other hand, compared to planar waterways, three-dimensional (3D) waterways offer greater freedom in component layout and structural design. Thus, 3D waterways provide significant advantages in high-power-density power products. Most of the current waterway components, such as U-shaped waterways, use an integrated design. These integrated components are formed by die-casting or profile bending. However, the coolant cavity width is limited by these molding processes, and achieving a narrow width is difficult, which fails to meet the demand for reduced module size. Moreover, in order to ensure sufficient contact between the coolant and the inner walls and to enhance heat dissipation efficiency, separating fins are utilized in the conventional waterway modules to divide the flow path into multiple micro-channels. This method increases process complexity, manufacturing costs, and flow resistance. Additionally, the waterway modules produced via profile bending are susceptible to stress concentration and deformation at the bends. Such modules require extra processing to ensure precision, and the complexity and the costs are further increased.

In view of the above, there is a need to develop a liquid cooling channel assembly and a power module using the same, to achieve optimized heat dissipation performance through a flexible modular design, and to obviate the drawbacks encountered by the prior arts.

### SUMMARY OF THE INVENTION

An object of the present disclosure is to provide a liquid cooling channel assembly and a power module using the same. By dividing an independent U-shaped channel into two lateral linear flow channel components and a curved component, the lateral linear flow channel components and the curved component are combined with a front-end component, so that each component is assembled modularly to flexibly achieve optimized heat dissipation performance for the power module. It allows the lateral linear flow channel component to form a flattened internal chamber through profiles, stampings, or die-castings. The length and width of the flattened internal chamber are not limited by the molding process and are adjustable according to the practical requirements. Certainly, each linear flow channel component is formed by a lateral flow plate with a groove and a lateral cover plate. The lateral flow plate and the lateral cover plate are fixedly connected through friction stir welding, laser welding, brazing, diffusion welding, electron beam welding, or sealant bonding, which is more conducive to reducing component thickness. Furthermore, the curved component and the front-end component are formed by die-casting to provide sufficient structural support and are modularly joined to the lateral linear flow channel components through the aforementioned welding or bonding methods. On the other hand, when the liquid cooling channel assembly is applied to a power module, the opposite inner heat dissipation surfaces of the lateral linear flow channel components are corresponding and thermally coupled to the opposite sides of a magnetic component, and the outer heat dissipation surfaces are thermally coupled to through-hole or surface-mounted devices, respectively. Additionally, the curved component provides another outer heat dissipation surface for application. Thus, the lateral linear flow channel components and the curved components are modularly assembled with the front-end component for flexible adjustment based on the quantity, size, and layout of heat-generating devices, so that the development costs and the lead times for cooling modules are reduced sufficiently. Since the front-end component, the two lateral linear flow channel components and the curved component have simplified structures in design, the components of the liquid cooling channel assembly can be manufactured through multiple molding processes with lower costs. Moreover, the liquid cooling channel assembly is seal-fitted with a chassis through an engagement portion of the front-end component; the engagement portion is not limited to a trapezoidal shape with a full-circle groove or a protrusion. The front-end component and the curved component are fixed to the chassis through screws, followed by thermal glue filling to further enhance heat dissipation. The present disclosure utilizes the simple modular connection of the front-end component, the two lateral linear flow channel components and the curved component to achieve the heat dissipation, the installation and the sealing without affecting the assembly of the inlet tube, the outlet tube, the bottom plate and the outer cover. Compared to the conventional single-piece designs, the liquid cooling channel assembly of the present disclosure offers greater versatility. It requires only size adjustments of certain structural components for low-cost adaptation to different heat dissipation scenarios. It should be understood that "abutting" or "contacting" as mentioned herein does not imply direct contact, but also includes cases with an air gap or the insertion of an insulating medium therebetween.

In accordance with an aspect of the present disclosure, a liquid cooling channel assembly is provided. The liquid cooling channel assembly includes a front-end component, a curved component, a first lateral linear flow channel component and a second lateral linear flow channel component. The front-end component includes an inlet, an outlet and a connection side. The inlet and the outlet are disposed at the connection side. The curved component has a first communication end and a second communication end opposite to each other. The first lateral linear flow channel component is extended along a first horizontal direction and in communication between the inlet and the first communication end. The second lateral linear flow channel component is extended along a second horizontal direction and in communication between the outlet and the second communication end. The first and second lateral linear flow channel components are spaced apart from each other to form two opposite inner heat dissipation surfaces and two opposite outer heat dissipation surfaces. A first heat-generating device is thermally connected to the two opposite inner heat dissipation surfaces, and a second heat-generating device is thermally connected to at least one of the two opposite outer heat dissipation surfaces.

In accordance with an aspect of the present disclosure, a power module is provided. The power module includes a liquid cooling channel assembly, a first heat-generating device and at least one second heat-generating device. The liquid cooling channel assembly includes a front-end component, a first lateral linear flow channel component, a second lateral linear flow channel component and a curved component, wherein the front-end component includes an inlet, an outlet and a connection side, the inlet and the outlet are disposed at the connection side, respectively, the curved component has a first communication end and a second communication end opposite to each other, the first lateral linear flow channel component is extended along a first horizontal direction and in communication between the inlet and the first communication end, and the second lateral linear flow channel component is extended along a second horizontal direction and in communication between the outlet and the second communication end, wherein the first lateral linear flow channel component and the second lateral linear flow channel component are spaced apart from each other to form two opposite inner heat dissipation surfaces and two opposite outer heat dissipation surfaces. The first heat-generating device is disposed between the first lateral linear flow channel component and the second lateral linear flow channel component, and thermally connected to the two opposite inner heat dissipation surfaces. The at least one second heat-generating device is disposed adjacent to the first lateral linear flow channel component and/or the second lateral linear flow channel component and/or the curved component, and correspondingly thermally connected to at least one of the two opposite outer heat dissipation surfaces and/or an outer heat dissipation surface of the curved component.

The beneficial effects of the present disclosure are that the embodiments of the present disclosure provide a liquid cooling channel assembly and a power module using the same. By dividing an independent U-shaped liquid cooling channel module into a front-end component, two lateral linear flow channel components and a curved component, each component is assembled modularly to flexibly achieve the optimized heat dissipation performance for the power module. It requires only size adjustments of certain structural components for low-cost adaptation to different heat dissipation scenarios. Thus, the liquid cooling channel assembly of the present disclosure offers greater versatility.

### BRIEF DESCRIPTION OF THE DRAWINGS

The above contents of the present disclosure will become more readily apparent to those ordinarily skilled in the art after reviewing the following detailed description and accompanying drawings, in which:
FIG. 1 is a structural perspective view illustrating a power module according to a first embodiment of the present disclosure;
FIG. 2 is a structural exploded view illustrating the power module according to the first embodiment of the present disclosure from a top perspective;
FIG. 3 is a structural exploded view illustrating the power module according to the first embodiment of the present disclosure from a bottom perspective;
FIG. 4 is a structural exploded view illustrating the liquid cooling channel assembly according to the first embodiment of the present disclosure;
FIG. 5 is a structural exploded view illustrating the liquid cooling channel assembly according to the first embodiment of the present disclosure from another perspective;
FIG. 6 is a horizontal cross-sectional view illustrating the power module according to the first embodiment of the present disclosure;
FIG. 7 is a vertical cross-sectional view illustrating the power module according to the first embodiment of the present disclosure;
FIG. 8 is a structural exploded view illustrating a power module according to a second embodiment of the present disclosure from a top perspective;
FIG. 9 is a structural exploded view illustrating the power module according to the second embodiment of the present disclosure from a bottom perspective;
FIG. 10 is a structural exploded view illustrating the liquid cooling channel assembly according to the second embodiment of the present disclosure;
FIG. 11 is a structural exploded view illustrating the liquid cooling channel assembly according to the second embodiment of the present disclosure from another perspective;
FIG. 12 is a horizontal cross-sectional view illustrating the power module according to the second embodiment of the present disclosure;
FIG. 13 is a vertical cross-sectional view illustrating the power module according to the second embodiment of the present disclosure;
FIG. 14 is a structural exploded view illustrating a power module according to a third embodiment of the present disclosure from a top perspective;
FIG. 15 is a structural exploded view illustrating the power module according to the third embodiment of the present disclosure from a bottom perspective;
FIG. 16 is a structural exploded view illustrating the liquid cooling channel assembly according to the third embodiment of the present disclosure;
FIG. 17 is a structural exploded view illustrating the liquid cooling channel assembly according to the third embodiment of the present disclosure from another perspective;
FIG. 18 is a horizontal cross-sectional view illustrating the power module according to the third embodiment of the present disclosure; and
FIG. 19 is a vertical cross-sectional view illustrating the power module according to the third embodiment of the present disclosure.

### DETAILED DESCRIPTION

The present disclosure will now be described more specifically with reference to the following embodiments. It is to be noted that the following descriptions of embodiments of this disclosure are presented herein for purpose of illustration and description only. It is not intended to be exhaustive or to be limited to the precise form disclosed. For example, the formation of a first feature over or on a second feature in the description that follows may include embodiments in which the first and second features are formed in direct contact, and may also include embodiments in which additional features may be formed between the first and second features, such that the first and second features may not be in direct contact. In addition, the present disclosure may repeat reference numerals or letters in the various examples. This repetition is for the purpose of simplicity and clarity and does not in itself dictate a relationship between the various embodiments or configurations discussed. Further, spatially relative terms, such as "upper," "lower," "front" , "rear," "left," "right", "top," "bottom" and the like, may be used herein for ease of description to describe one element or feature's relationship to another element(s) or feature(s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly. When an element is referred to as being "connected," or "coupled," to another element, it can be directly connected or coupled to the other element or intervening elements may be present. Although the wide numerical ranges and parameters of the present disclosure are approximations, numerical values are set forth in the specific examples as precisely as possible. In addition, although the "first," "second," and the like terms in the claims be used to describe the various elements can be appreciated, these elements should not be limited by these terms, and these elements are described in the respective embodiments are used to express the different reference numerals, these terms are only used to distinguish one element from another element. For example, a first element could be termed a second element, and, similarly, a second element could be termed a first element, without departing from the scope of example embodiments. Besides, "and / or" and the like may be used herein for including any or all combinations of one or more of the associated listed items. Alternatively, the word "about" means within an acceptable standard error of ordinary skill in the art-recognized average. In addition to the operation / working examples, or unless otherwise specifically stated otherwise, in all cases, all of the numerical ranges, amounts, values and percentages, such as the number for the herein disclosed materials, time duration, temperature, operating conditions, the ratio of the amount, and the like, should be understood as the word "about" decorator. Accordingly, unless otherwise indicated, the numerical parameters of the present invention and scope of the appended patent proposed is to follow changes in the desired approximations. At least, the number of significant digits for each numerical parameter should at least be reported and explained by conventional rounding technique is applied. Herein, it can be expressed as a range between from one endpoint to the other or both endpoints. Unless otherwise specified, all ranges disclosed herein are inclusive.

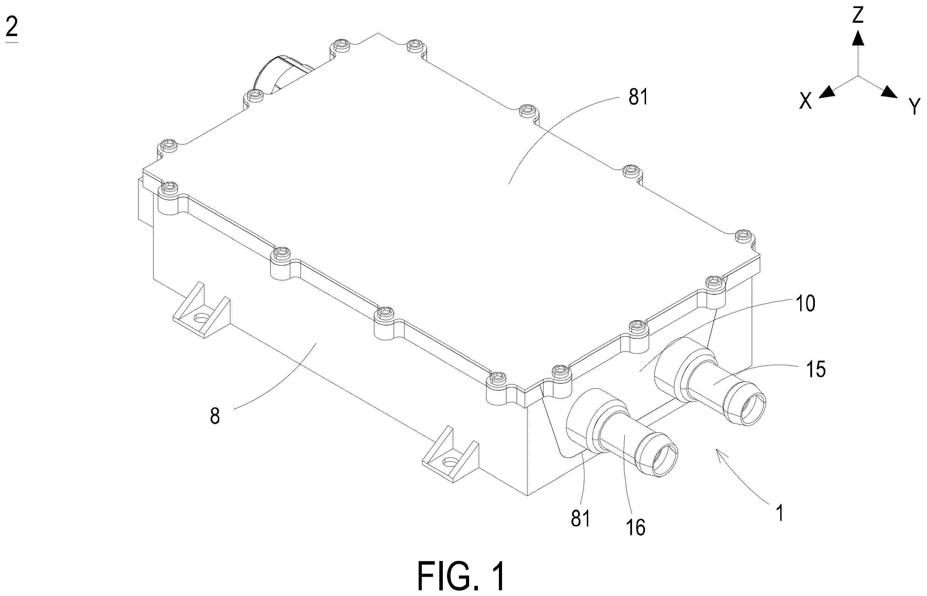

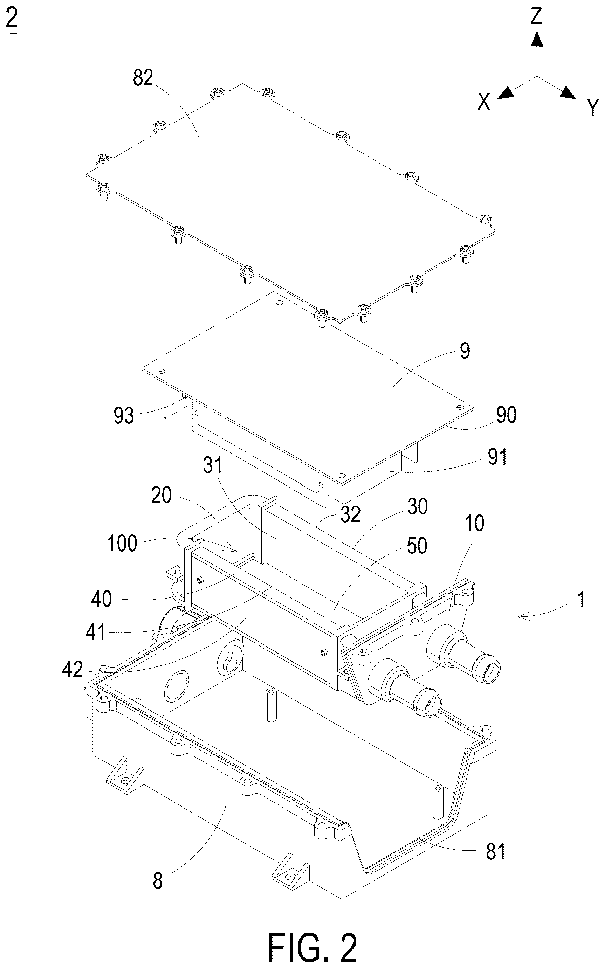

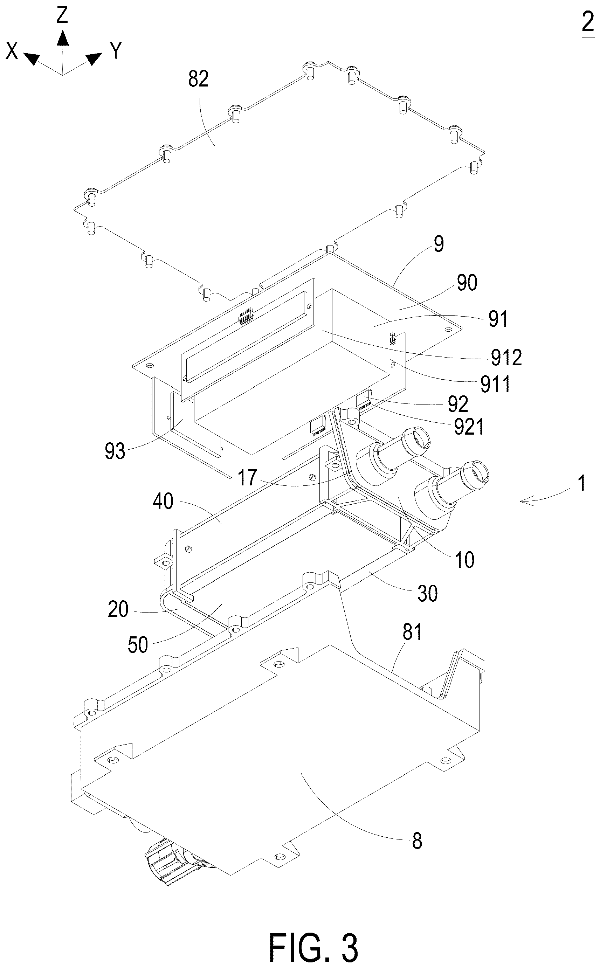

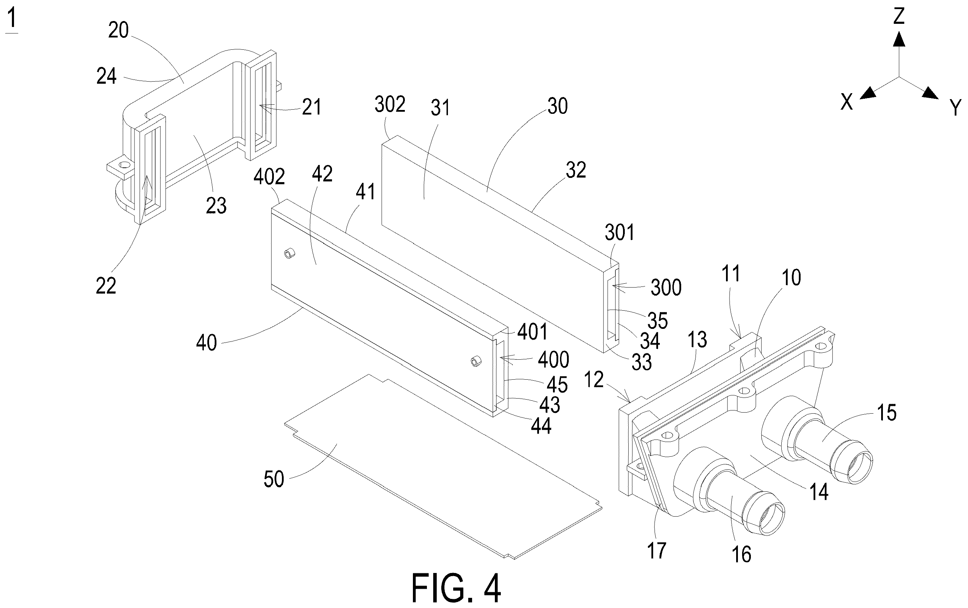

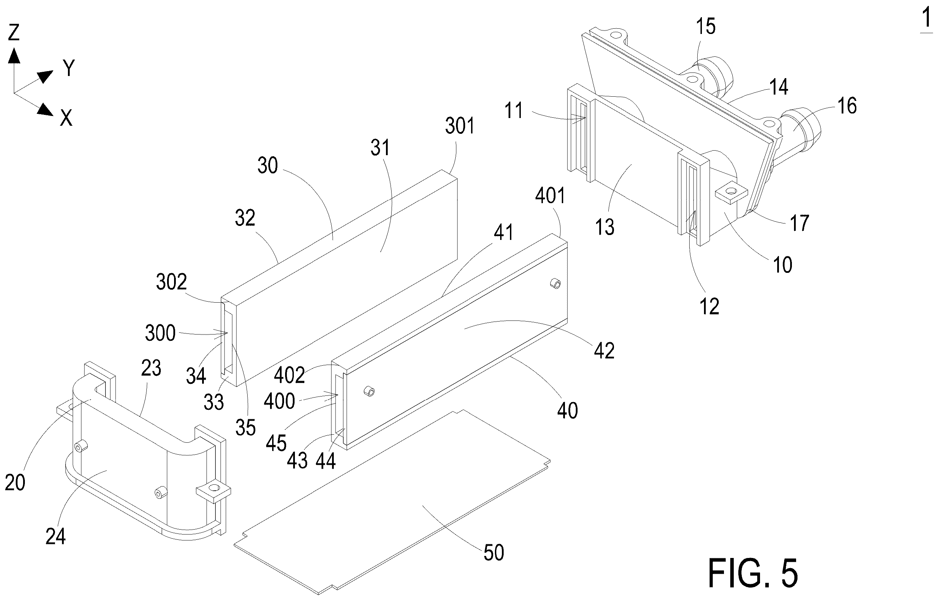

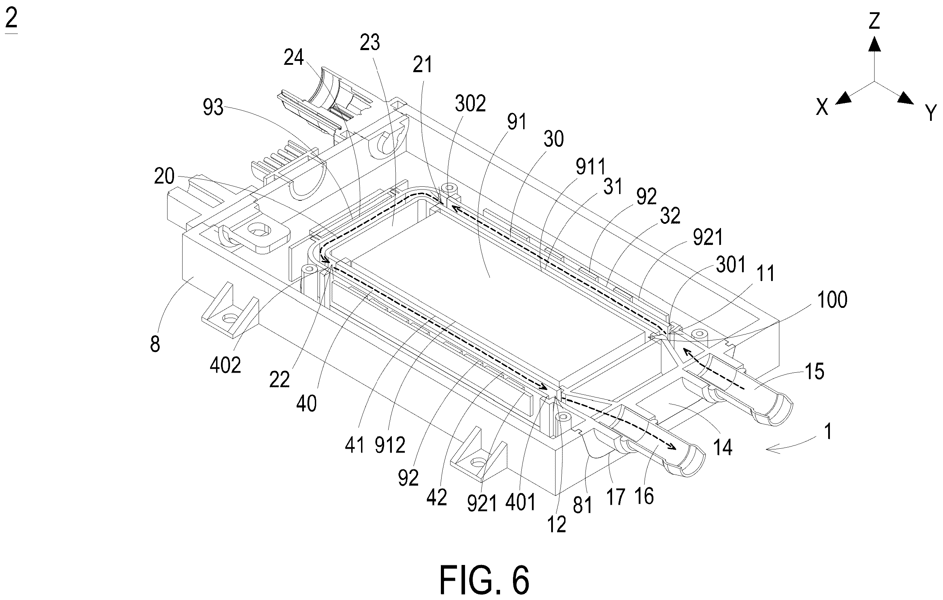

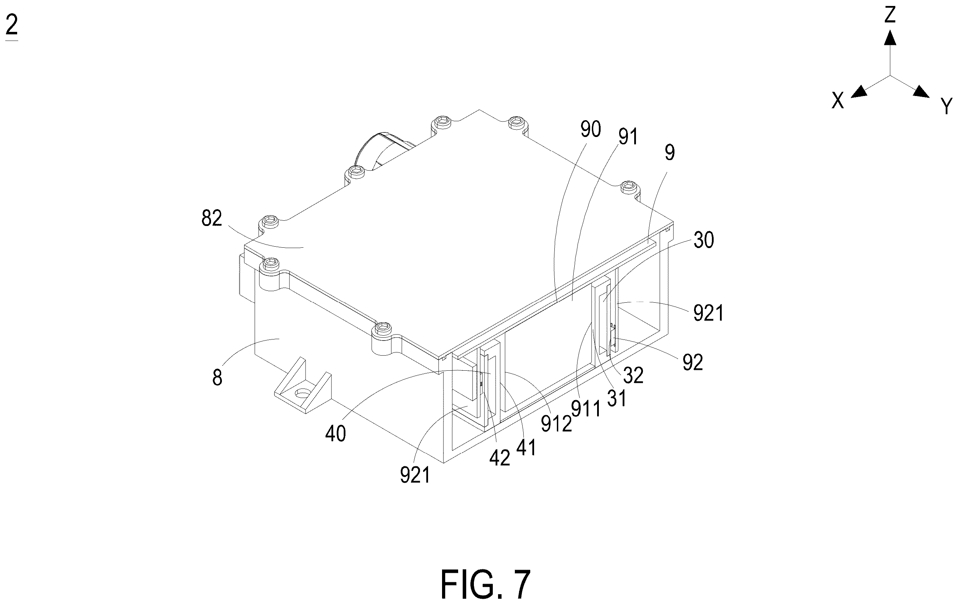

FIG. 1 is a structural perspective view illustrating a power module according to a first embodiment of the present disclosure. FIG. 2 and FIG. 3 are structural exploded views illustrating the power module according to the first embodiment of the present disclosure. FIG. 4 and FIG. 5 are structural exploded views illustrating the power module according to the first embodiment of the present disclosure. FIG. 6 is a horizontal cross-sectional view illustrating the power module according to the first embodiment of the present disclosure. FIG. 7 is a vertical cross-sectional view illustrating the power module according to the first embodiment of the present disclosure. In the embodiment, the present disclosure provides a power module 2, for example, applied to an on-board charger. The power module 2 includes a liquid cooling channel assembly 1, a first heat-generating device 91 and at least one second heat-generating device 92. Notably, the power module 2 further includes a top PCB 9 having a bottom surface 90, and the bottom surface 90 is spatially corresponding to the liquid cooling channel assembly 1. In one embodiment, the first heat-generating device 91 and the at least one second heat-generating device 92 having heat dissipation requirements in the power module 2 are disposed on the bottom surface 90 of the top PCB 9, and are thermally coupled to the liquid cooling channel assembly 1, respectively. In one embodiment, the first heat-generating device 91 is a magnetic component, the at least one second heat-generating device 92 is a power device, and the power device is more specifically a surface-mounted power device, which is surface-mounted to a side PCB 921. Certainly, the present disclosure is not limited thereto.

Notably, in the embodiment, the liquid cooling channel assembly 1 includes a front-end component 10, a first lateral linear flow channel component 30, a second lateral linear flow channel component 40 and a curved component 20. The front-end component 10 includes an inlet 11, an outlet 12 and a connection side 13. In one embodiment, the inlet 11 and the outlet 12 are disposed at opposite ends of the connection side 13, respectively, for example the left end and the right end. The curved component 20 has a first communication end 21 and a second communication end 22 opposite to each other. In one embodiment, the first communication end 21 and the second communication end 22 are disposed at opposite ends of a communication side 23, respectively, for example the left end and the right end. In the embodiment, the first lateral linear flow channel component 30 is extended along a first horizontal direction (for example, parallel to the Y-axis direction) and in communication between the inlet 11 and the first communication end 21. The second lateral linear flow channel component 40 is extended along a second horizontal direction and is in communication between the outlet 12 and the second communication end 22. In one embodiment, the second horizontal direction is the same as the first horizontal direction, or a certain angular deviation is formed therebetween. The present disclosure is not limited thereto. The first lateral linear flow channel component 30 and the second lateral linear flow channel component 40 are spaced apart from each other to form two opposite inner heat dissipation surfaces 31, 41 and two opposite outer heat dissipation surfaces 32, 42.

In the embodiment, after the liquid cooling channel assembly 1, the first heat-generating device 91 and the at least one second heat-generating device 92 are assembled, the first heat-generating device 91 is disposed between the inner heat dissipation surface 31 of the first lateral linear flow channel component 30 and the inner heat dissipation surface 41 of the second lateral linear flow channel component 40, and two opposite sidewalls 911, 912 of the first heat-generating device 91 are thermally connected to the two opposite inner heat dissipation surfaces 31, 41, respectively. The at least one second heat-generating device 92 is disposed adjacent to the first lateral linear flow channel component 30 and/or the second lateral linear flow channel component 40, and correspondingly thermally connected to at least one of the two opposite outer heat dissipation surfaces 32, 42. In addition, the bottom surface 90 of the top PCB 9 abuts against tops of the front-end component 10, the first lateral linear flow channel component 30, the second lateral linear flow channel component 40 and the curved component 20, and the first lateral linear flow channel component 30 and/or the second lateral linear flow channel component 40 are respectively located between the first heat-generating device 91 and the at least one second heat-generating device 92. Since the first heat-generating device 91 and the at least one second heat-generating device 92 are disposed on the bottom surface 90, the liquid cooling channel assembly 1 also provides a support function when performing heat dissipation in combination with the first heat-generating device 91 and the at least one second heat-generating device 92. Certainly, the present disclosure is not limited thereto. Notably, the front-end component 10, the first lateral linear flow channel component 30, the second lateral linear flow channel component 40 and the curved component 20 of the liquid cooling channel assembly 1 are assembled by splicing. By dividing an independent U-shaped channel into the first lateral linear flow channel component 30 and the second lateral linear flow channel component 40 on two sides and the curved component 20, and then combining them with the front-end component 10, the optimized heat dissipation performance of the power module 2 is flexibly achieved corresponding to the dimensions and configuration of the first heat-generating device 91 and the at least one second heat-generating device 92.

In the embodiment, the first lateral linear flow channel component 30 and the second lateral linear flow channel component 40 have, for example but not limited to, the same structure and are used interchangeably. In the embodiment, the first lateral linear flow channel component 30 has a first front end 301 and a first back end 302 opposite to each other. The first front end 301 is connected to the inlet 11, and the first back end 302 is connected to the first communication end 21. Similarly, the second lateral linear flow channel component 40 has a second front end 401 and a second back end 402 opposite to each other. The second front end 401 is connected to the outlet 12, and the second back end 402 is connected to the second communication end 22. In the embodiment, the first lateral linear flow channel component 30 includes a first lateral flow channel plate 33 and a first lateral cover plate 34. The first lateral flow channel plate 33 has a first groove 35 extended along a first horizontal direction (for example, parallel to the Y-axis direction), and the first lateral cover plate 34 is connected to the first lateral flow channel plate 33 and covers the first groove 35 to form a first flattened internal chamber 300 communicating between the first front end 301 and the first back end 302. Similarly, the second lateral linear flow channel component 40 includes a second lateral flow channel plate 43 and a second lateral cover plate 44. The second lateral flow channel plate 43 has a second groove 45 extended along a second horizontal direction, and the second lateral cover plate 44 is connected to the second lateral flow channel plate 43 and covers the second groove 45 to form a second flattened internal chamber 400 communicating between the second front end 401 and the second back end 402. In the embodiment, the first lateral flow channel plate 33 and the first lateral cover plate 34, as well as the second lateral flow channel plate 43 and the second lateral cover plate 44, are fixedly connected through friction stir welding, laser welding, brazing, diffusion welding or sealant bonding.

Notably, in the embodiment, the first lateral linear flow channel component 30 and the second lateral linear flow channel component 40 are constituted by extruded profile parts, stamping parts, or die-casting parts to form the flattened internal chambers 300, 400, and the length and width of the chambers are not limited by the molding process and adjustable according to the practical requirements. Certainly, each of the first lateral linear flow channel component 30 and the second lateral linear flow channel component 40 is formed by a lateral flow channel plate with a groove and a lateral cover plate. In the embodiment, the lateral flow channel plate and the lateral cover plate are assembled through friction stir welding, laser welding, brazing, diffusion welding, electron beam welding or sealant bonding, which is more conducive to reducing the thickness of the components.

In addition, in the embodiment, the curved component 20 and the front-end component 10 are constituted by die-casting parts, and have a structural strength thereof greater than or equal to a structural strength of the first lateral linear flow channel component 30 and the second lateral linear flow channel component 40, which helps to provide sufficient structural support. Furthermore, the first lateral linear flow channel component 30 and the second lateral linear flow channel component 40 are fixedly connected to the curved component 20 and/or the front-end component 10 through friction stir welding, laser welding, brazing, diffusion welding, electron beam welding or sealant bonding, respectively, to achieve modular splicing.

In the embodiment, when the liquid cooling channel assembly 1 is applied to the power module 2, the inner heat dissipation surface 31 of the first lateral linear flow channel component 30 and the inner heat dissipation surface 41 of the second lateral linear flow channel component 40 on the two opposite sides are corresponding and thermally couple to the two opposite sidewalls 911, 912 of the first heat-generating device 91 (e.g., a magnetic component). Moreover, the outer heat dissipation surface 32 of the first lateral linear flow channel component 30 and the outer heat dissipation surface 42 of the second lateral linear flow channel component 40 on the two opposite sides are thermally coupled to the second heat-generating device 92 (e.g., a surface-mounted power device), respectively. In the embodiment, the curved component 20 also provides another outer heat dissipation surface 24 for application, which is opposite to the communication side 23 and thermally coupled to another heat-generating device 93. In other embodiments, according to different dimension requirements of the first heat-generating device 91, it allows the liquid cooling channel assembly 1 to meet the different dimension requirements of the first heat-generating device 91 by adjusting the lengths of the first lateral linear flow channel component 30 and the second lateral linear flow channel component 40, or by replacing the curved component 20 and the front-end component 10 to adjust the spacing distance between the first lateral linear flow channel component 30 and the second lateral linear flow channel component 40. Certainly, the modification of the liquid cooling channel assembly 1 is adjustable according to the practical requirements. Thus, the modular disassembly and the connection of the first lateral linear flow channel component 30, the second lateral linear flow channel component 40, the curved component 20 and the front-end component 10 are flexibly adjustable based on the quantity, the size and the layout of the heat-generating devices 91, 92, 93, and the development costs and the lead times for the liquid cooling channel modules applicable to the power module 2 are reduced sufficiently. Furthermore, since the front-end component 10, the first lateral linear flow channel component 30, the second lateral linear flow channel component 40 and the curved component 20 have simplified structures in design, the components of the liquid cooling channel assembly 1 can be manufactured through multiple molding processes with lower costs.

In the embodiment, the liquid cooling channel assembly 1 further includes a bottom plate 50, disposed below the front-end component 10, the first lateral linear flow channel component 30, the second lateral linear flow channel component 40 and the curved component 20 to form an accommodation space 100 for accommodating the first heat-generating device 91. The first heat-generating device 91 is thermally connected to the inner heat dissipation surface 31 of the first lateral linear flow channel component 30 and the inner heat dissipation surface 41 of the second lateral linear flow channel component 40. In one embodiment, the first heat-generating device 91 is also directly or indirectly thermally connected to the front-end component 10, the curved component 20 and the bottom plate 50. In the embodiment, the first heat-generating device 91 and the second heat-generating device 92 are disposed on the bottom surface 90 of the top PCB 9. The top PCB 9 is disposed above the front-end component 10, the first lateral linear flow channel component 30, the second lateral linear flow channel component 40 and the curved component 20. The bottom surface 90 abuts against the tops of the front-end component 10, the first lateral linear flow channel component 30, the second lateral linear flow channel component 40 and the curved component 20, thereby obtaining stable support. In one embodiment, the second heat-generating device 92 is disposed on the side PCB 921, and the side PCB 921 also abuts against the outer heat dissipation surfaces 32, 42. The side PCB 921 is disposed on the bottom surface 90 of the top PCB 9.

In the embodiment, the power module 2 further includes a chassis 8 for accommodating and fixing the liquid cooling channel assembly 1. In the embodiment, the front-end component 10 further includes an inlet tube 15 and an outlet tube 16 disposed at a front side 14 opposite to the connection side 13. The inlet tube 15 communicates to the inlet 11, and the outlet tube 16 communicates to the outlet 12. In the embodiment, a coolant (not shown) enters from the inlet tube 15, flows through the inlet 11, the first lateral linear flow channel component 30, the first communication end 21 and the second communication end 22 of the curved component 20, the second lateral linear flow channel component 40 and the outlet 12, and is discharged through the outlet tube 16. In the embodiment, the front-end component 10 further includes an engagement portion 17 disposed between the connection side 13, the inlet tube 15 and the outlet tube 16. The engagement portion 17 is engaged with a sidewall 81 of the chassis 8. In the embodiment, the first lateral linear flow channel component 30, the second lateral linear flow channel component 40 and the curved component 20 are accommodated in the chassis 8, and the inlet tube 15 and the outlet tube 16 are extended outwardly. In the embodiment, the front-end component 10 and the curved component 20 are fixed to the chassis 8 through screws, respectively. In other embodiments, the first lateral linear flow channel component 30 and the second lateral linear flow channel component 40 are fixed to the chassis 8 through screws or other engagement methods, and the present disclosure is not limited thereto. In the embodiment, the power module 2 further includes an outer cover 82 fixed to the chassis 8 and covering the liquid cooling channel assembly 1, the first heat-generating device 91 and the at least one second heat-generating device 92. In some embodiments, the outer cover 82 and the chassis 8 are fixedly connected through bolts. In an embodiment, the power module 2 further includes thermal glue (not shown) filled in the liquid cooling channel assembly 1 and/or the chassis 8. The present disclosure is not limited thereto. Notably, since the liquid cooling channel assembly 1 is seal-fitted with the external chassis 8 through the engagement portion 17 of the front-end component 10, the assembly process of the power module 2 is simplified. In certain embodiments, the engagement portion 17 of the front-end component 10 is not limited to a trapezoidal shape with a full-circle groove or a protrusion, which can be seal-fitted with the external chassis 8. In other embodiments, the front-end component 10 and the curved component 20 are fixed to the chassis 8 through screws, respectively, followed by thermal glue filling to further enhance the heat dissipation performance. Certainly, the present disclosure is not limited thereto.

Notably, the liquid cooling channel assembly 1 of the present disclosure utilizes the modular structural disassembly and connection of the front-end component 10, the first lateral linear flow channel component 30, the second lateral linear flow channel component 40 and the curved component 20 to achieve the heat dissipation, the installation, the fixation and the sealing design of the overall cooling channel module without affecting the splicing of the inlet tube 15, the outlet tube 16, the bottom plate 50 and the outer cover 82. Compared with the conventional single-piece cooling channel design, the liquid cooling channel assembly 1 of the present disclosure has greater versatility. For heat dissipation scenarios that need to adapt to different lengths and widths, only the dimensions of some structural components of the present disclosure need to be changed to achieve low-cost adaptation.

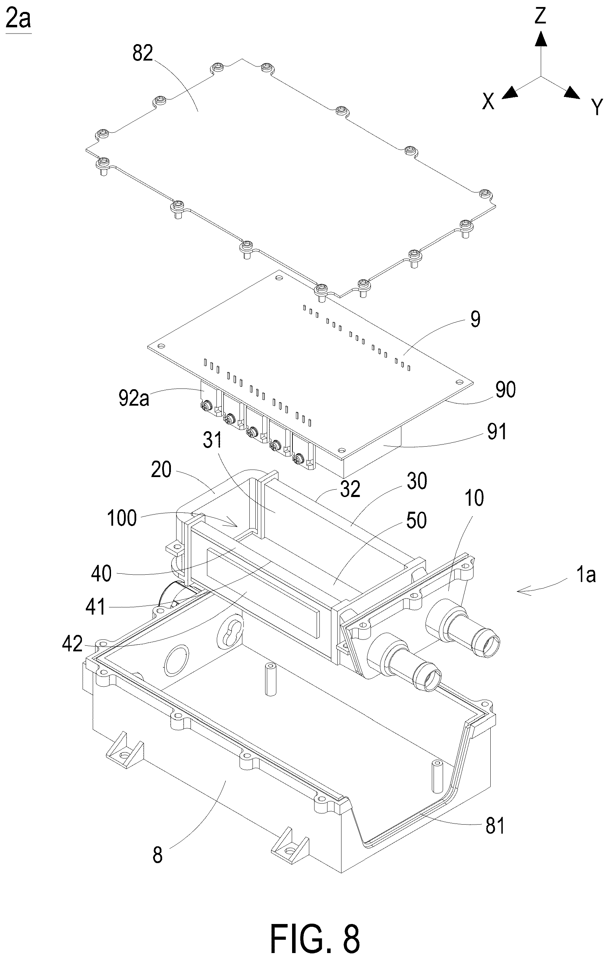

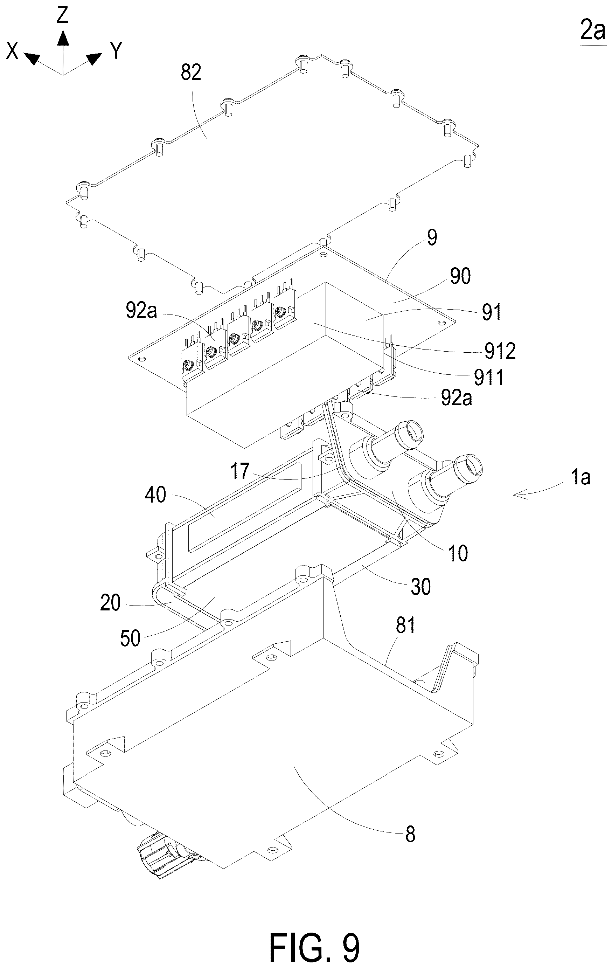

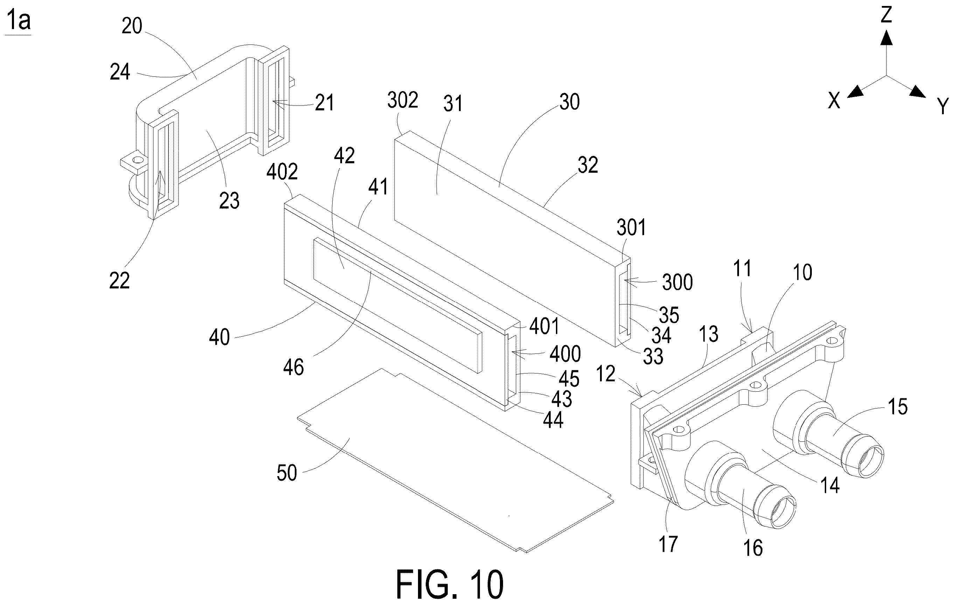

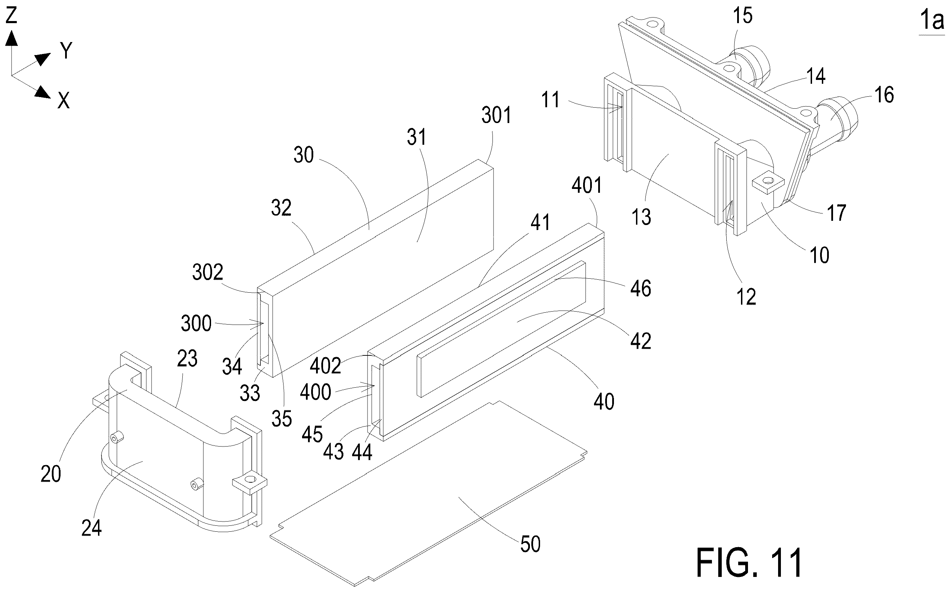

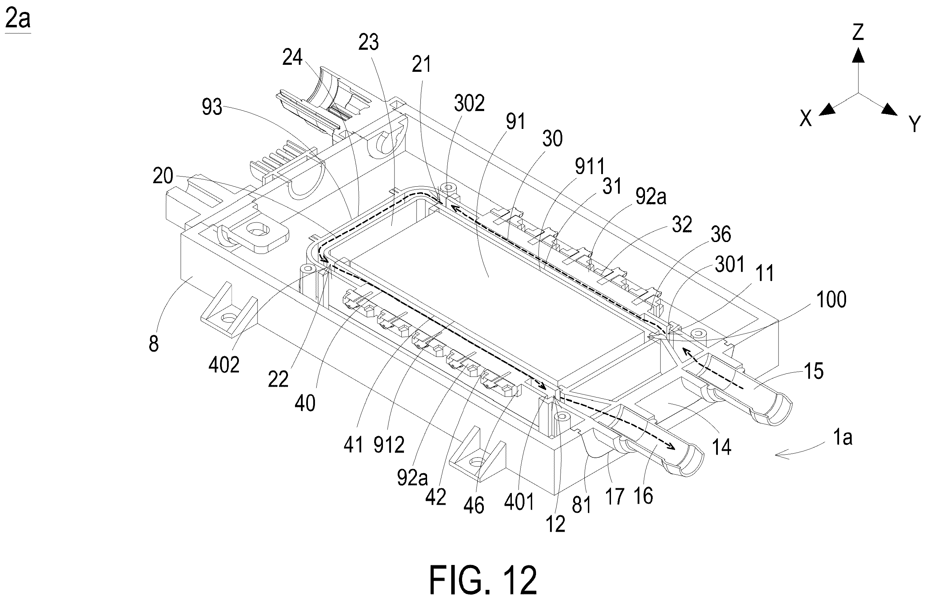

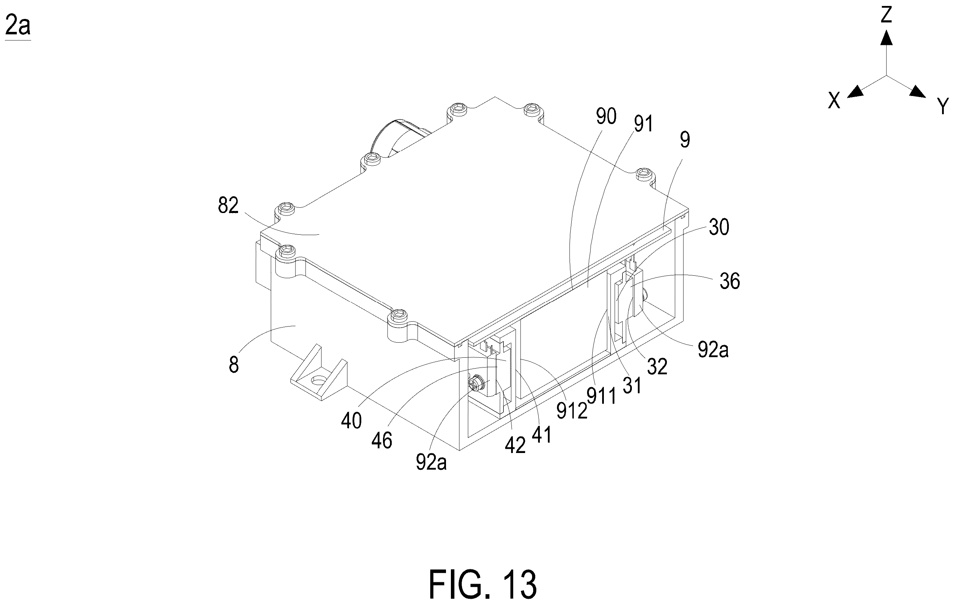

FIG. 8 and FIG. 9 are structural exploded views illustrating a power module according to a second embodiment of the present disclosure. FIG. 10 and FIG. 11 are structural exploded views illustrating the liquid cooling channel assembly according to the second embodiment of the present disclosure. FIG. 12 is a horizontal cross-sectional view illustrating the power module according to the second embodiment of the present disclosure. FIG. 13 is a vertical cross-sectional view illustrating the power module according to the second embodiment of the present disclosure. In the embodiment, the structures, elements and functions of the power module 2a and the liquid cooling channel assembly 1a are similar to those of the power module 2 and the liquid cooling channel assembly 1 in FIG. 1 to FIG. 7, and are not redundantly described herein. In the embodiment, the power module 2a includes a liquid cooling channel assembly 1a, a first heat-generating device 91 and a plurality of second heat-generating devices 92a. In one embodiment, the first heat-generating device 91 is a magnetic component, and the plurality of second heat-generating devices 92a are through-hole heat-generating devices, specifically through-hole devices. The first heat-generating device 91 and the plurality of second heat-generating devices 92a are disposed on the bottom surface 90 of the top PCB 9 and thermally coupled to the first lateral linear flow channel component 30 and the second lateral linear flow channel component 40 of the liquid cooling channel assembly 1a, respectively. In the embodiment, after the liquid cooling channel assembly 1a, the first heat-generating device 91 and the plurality of second heat-generating devices 92a are assembled, the first heat-generating device 91 is disposed between the inner heat dissipation surface 31 of the first lateral linear flow channel component 30 and the inner heat dissipation surface 41 of the second lateral linear flow channel component 40, and the two opposite sidewalls 911, 912 of the first heat-generating device 91 are thermally connected to the two opposite inner heat dissipation surfaces 31, 41, respectively. In addition, the plurality of second heat-generating devices 92a are arranged adjacent to the first lateral linear flow channel component 30 and the second lateral linear flow channel component 40, respectively, and thermally connected to the two opposite outer heat dissipation surfaces 32, 42, correspondingly.

In the embodiment, the first lateral linear flow channel component 30 and the second lateral linear flow channel component 40, for example but not limited to, have the same structure and can be used interchangeably. The first lateral linear flow channel component 30 includes a first lateral flow channel plate 33 and a first lateral cover plate 34. The first lateral flow channel plate 33 has a first groove 35 extended along a first horizontal direction (for example, parallel to the Y-axis direction), and the first lateral cover plate 34 is connected to the first lateral flow channel plate 33 and covers the first groove 35. The first groove 35 is in communication between the first front end 301 and the first back end 302. Similarly, the second lateral linear flow channel component 40 includes a second lateral flow channel plate 43 and a second lateral cover plate 44. The second lateral flow channel plate 43 has a second groove 45 extended along a second horizontal direction, and the second lateral cover plate 44 is connected to the second lateral flow channel plate 43 and covers the second groove 45. The second groove 45 is in communication between the second front end 401 and the second back end 402. Notably, the outer heat dissipation surface 32 formed by the first lateral cover plate 34 of the first lateral linear flow channel component 30 corresponds to the plurality of second heat-generating devices 92a, and the outer heat dissipation surface 42 formed by the second lateral cover plate 44 of the second lateral linear flow channel component 40 corresponds to the plurality of second heat-generating devices 92a. Since the plurality of second heat-generating devices 92a for example are through-hole devices, which are thermally connected to the heat dissipation devices through bolt fixation. In some embodiments, in order to facilitate the thermal connection between the plurality of second heat-generating devices 92a and the first lateral linear flow channel component 30, the first lateral cover plate 34 further includes a protrusion 36 protruding from the outer surface of the first lateral cover plate 34 to increase the thickness. The protrusion 36 is spatially corresponding to the plurality of second heat-generating devices 92a, so as to facilitate the fixation of the plurality of second heat-generating devices 92a to the outer heat dissipation surface 32 through bolt fixation and form a thermal connection. Similarly, in order to facilitate the thermal connection between the plurality of second heat-generating devices 92a and the second lateral linear flow channel component 40, the second lateral cover plate 44 further includes a protrusion 46 protruding from the outer surface of the second lateral cover plate 44 to increase the thickness. The protrusion 46 is spatially corresponding to the plurality of second heat-generating devices 92a, so as to facilitate the fixation of the plurality of second heat-generating devices 92a to the outer heat dissipation surface 42 through bolt fixation and form a thermal connection. In some embodiments, due to the diversity of the lateral linear cooling channels, the first lateral cover plate 34 and/or the second lateral cover plate 44 doesn't have the protrusions 36, 46, but instead have fixing pillars or screw holes, to make the second heat-generating devices 92a abut against and be fixed to the first lateral cover plate 34 and/or the second lateral cover plate 44. In other embodiments, the first lateral linear flow channel component 30 and the second lateral linear flow channel component 40 are constituted by extruded profile parts, stamping parts or die-casting parts, and the dimension of the chamber is not limited by the molding process and adjustable according to the practical requirements. In some embodiments, the first lateral flow channel plate 33 and the first lateral cover plate 34 for constituting the first lateral linear flow channel component 30, and the second lateral flow channel plate 43 and the second lateral cover plate 44 for constituting the second lateral linear flow channel component 40, are assembled through friction stir welding, laser welding, brazing, diffusion welding, electron beam welding or sealant bonding, which is more conducive to reducing the thickness of the components. Certainly, the types of the first lateral cover plate 34 and the second lateral flow channel plate 43 are adjustable according to the practical requirements to achieve diversified applications.

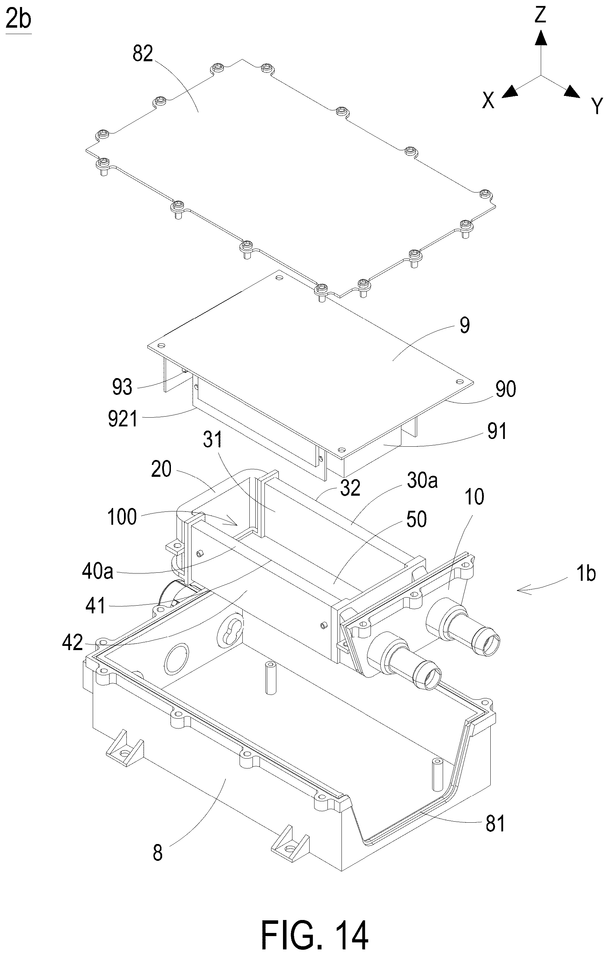

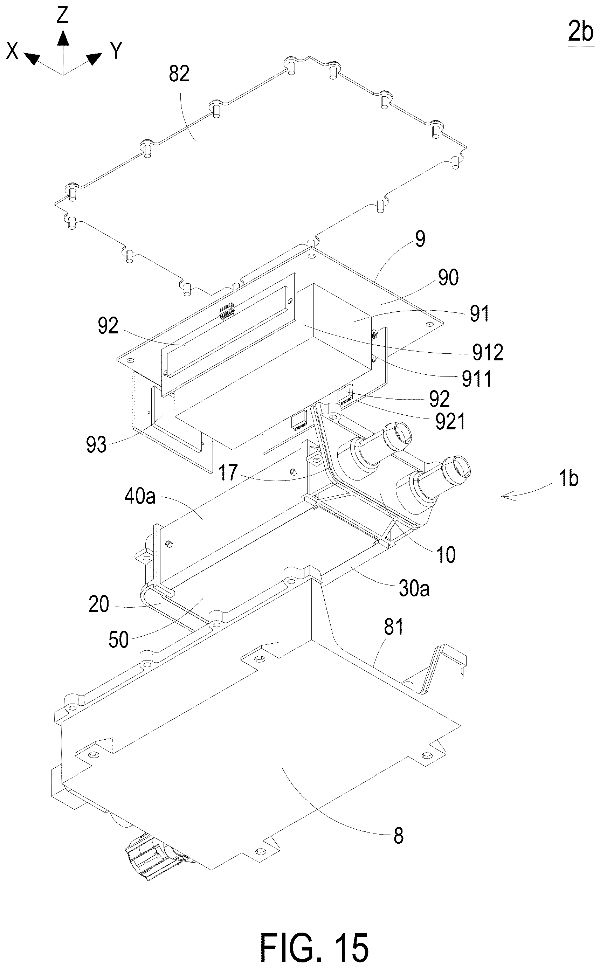

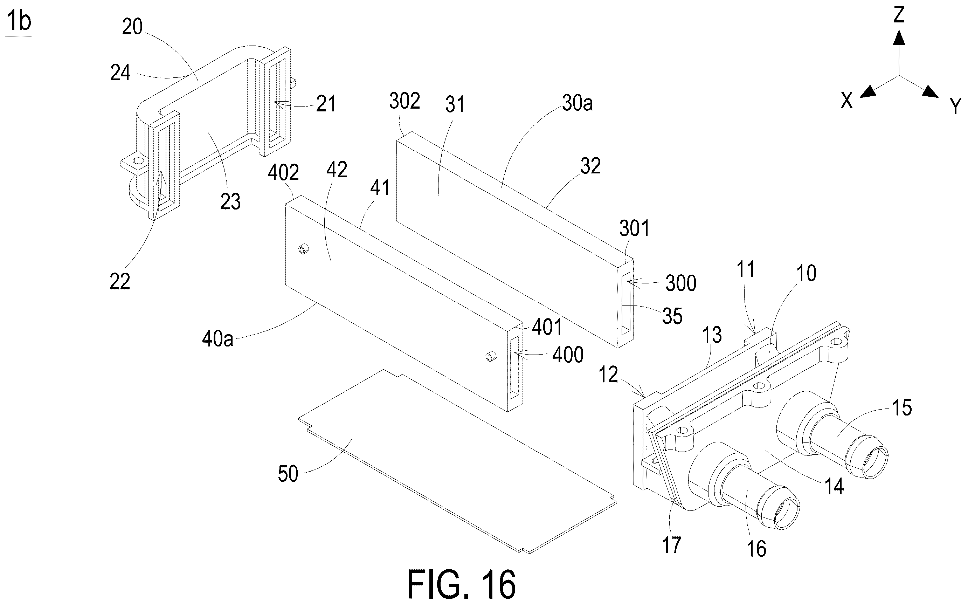

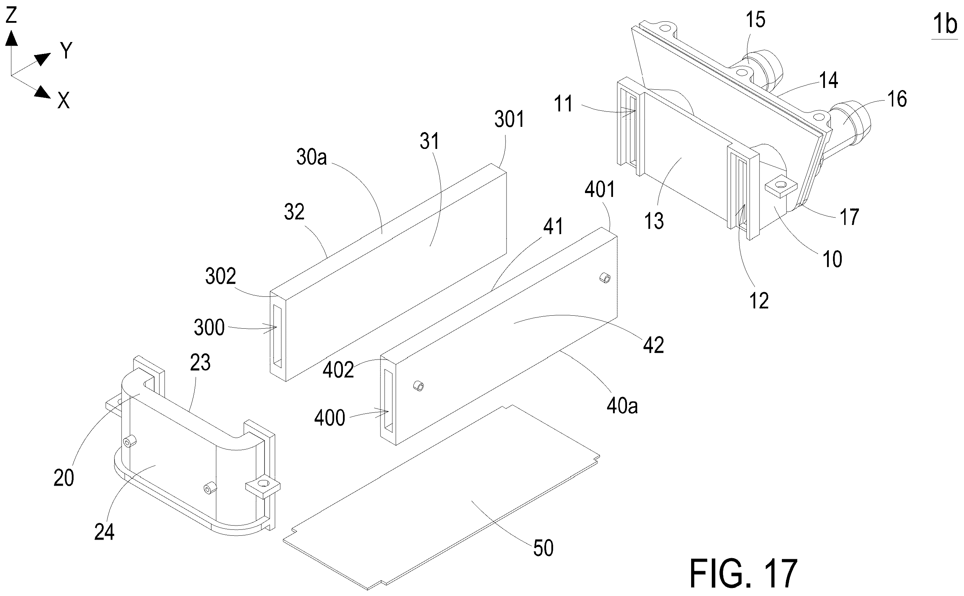

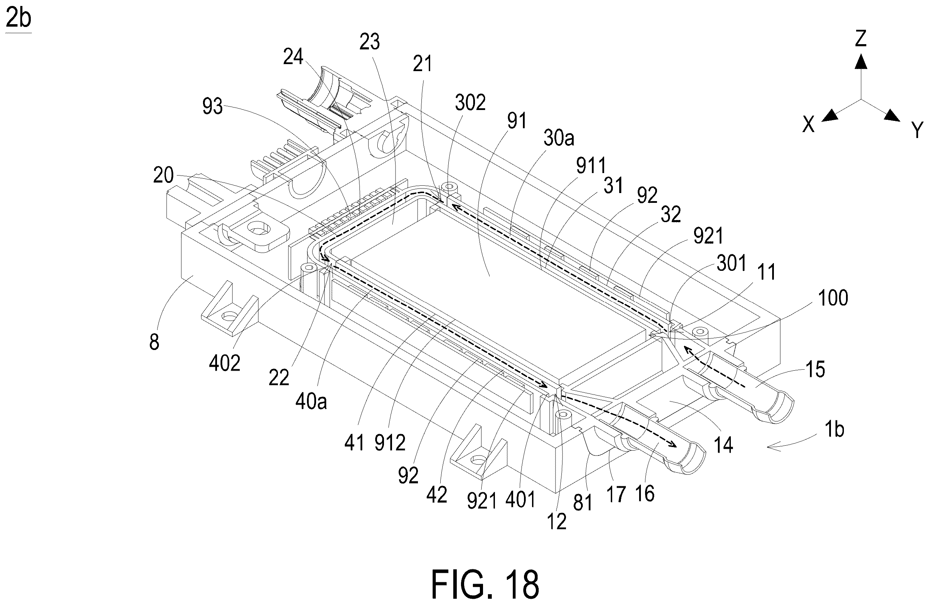

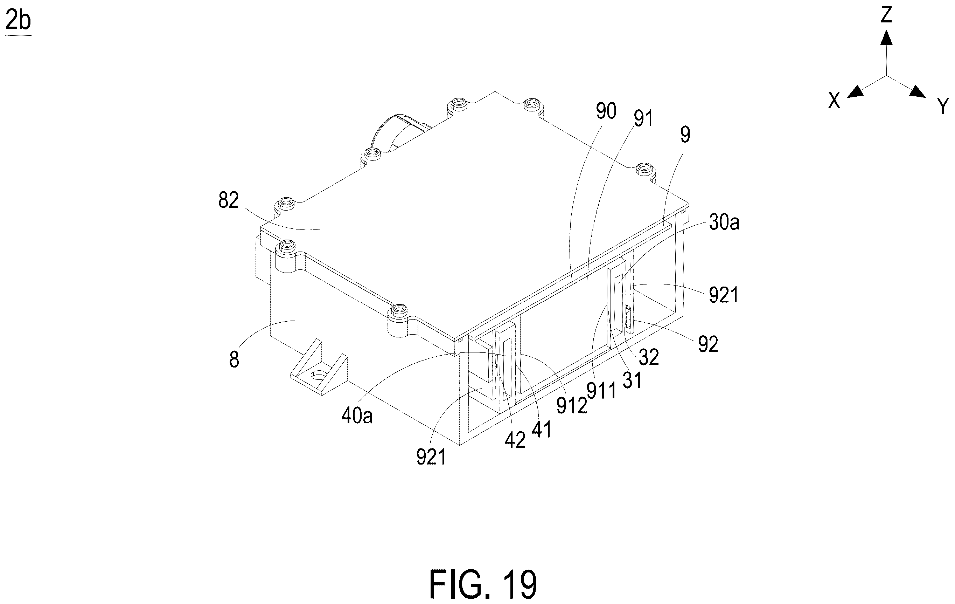

FIG. 14 and FIG. 15 are structural exploded views illustrating a power module according to a third embodiment of the present disclosure. FIG. 16 and FIG. 17 are structural exploded views illustrating the liquid cooling channel assembly according to the third embodiment of the present disclosure. FIG. 18 is a horizontal cross-sectional view illustrating the power module according to the third embodiment of the present disclosure. FIG. 19 is a vertical cross-sectional view illustrating the power module according to the third embodiment of the present disclosure. In the embodiment, the structures, elements and functions of the power module 2b and the liquid cooling channel assembly 1b are similar to those of the power module 2 and the liquid cooling channel assembly 1 in FIG. 1 to FIG. 7 and the power module 2a and the liquid cooling channel assembly 1a in FIG. 8 to FIG. 13, and are not redundantly described herein. In the embodiment, the power module 2b includes a liquid cooling channel assembly 1b for heat dissipation of heat-generating devices 91, 92, 93. Notably, in the embodiment, the first lateral linear flow channel component 30a and the second lateral linear flow channel component 40a of the liquid cooling channel assembly 1b are integral parts, which are assembled with the front-end component 10 and the curved component 20 through splicing. The first lateral linear flow channel component 30a is integrally formed through injection molding, casting or stamping to form an integrated part, which includes a first front end 301 and a first back end 302 opposite to each other, and a first flattened internal chamber 300 communicating between the first front end 301 and the first back end 302. Similarly, the second lateral linear flow channel component 40a is integrally formed through injection molding, casting or stamping to form an integrated part, which includes a second front end 401 and a second back end 402 opposite to each other, and a second flattened internal chamber 400 communicating between the second front end 401 and the second back end 402. In one embodiment, the first lateral linear flow channel component 30a and the second lateral linear flow channel component 40a, for example but not limited to, have the same structure and can be used interchangeably. Since the first lateral linear flow channel component 30a and the second lateral linear flow channel component 40a are constituted by integral parts, respectively, it is more beneficial to reduce the risk of liquid leakage and the difficulty of splicing when the integral parts are spliced and assembled with the front-end component 10 and the curved component 20. Certainly, the present disclosure is not limited thereto, and not redundantly described herein.

In summary, the present disclosure provides a liquid cooling channel assembly and a power module using the same. By dividing an independent U-shaped channel into two lateral linear flow channel components and a curved component, the lateral linear flow channel components and the curved component are combined with a front-end component, so that each component is assembled modularly to flexibly achieve optimized heat dissipation performance for the power module. It allows the lateral linear flow channel component to form a flattened internal chamber through profiles, stampings, or die-castings. The length and width of the flattened internal chamber are not limited by the molding process and adjustable according to the practical requirements. Certainly, each linear flow channel component is formed by a lateral flow plate with a groove and a lateral cover plate. The lateral flow plate and the lateral cover plate are fixedly connected through friction stir welding, laser welding, brazing, diffusion welding, electron beam welding, or sealant bonding, which is more conducive to reducing component thickness. Furthermore, the curved component and the front-end component are formed by die-casting to provide sufficient structural support and are modularly joined to the lateral linear flow channel components through the aforementioned welding or bonding methods. On the other hand, when the liquid cooling channel assembly is applied to a power module, the opposite inner heat dissipation surfaces of the lateral linear flow channel components are corresponding and thermally coupled to the opposite sides of a magnetic component, and the outer heat dissipation surfaces are thermally coupled to through-hole or surface-mounted devices, respectively. Additionally, the curved component provides another outer heat dissipation surface for application. Thus, the lateral linear flow channel components and the curved components are modularly assembled with the front-end component for flexible adjustment based on the quantity, size, and layout of heat-generating devices, so that the development costs and the lead times for cooling modules are reduced sufficiently. Since the front-end component, the two lateral linear flow channel components and the curved component have simplified structures in design, the components of the liquid cooling channel assembly can be manufactured through multiple molding processes with lower costs. Moreover, the liquid cooling channel assembly is seal-fitted with a chassis through an engagement portion of the front-end component; the engagement portion is not limited to a trapezoidal shape with a full-circle groove or a protrusion. The front-end component and the curved component are fixed to the chassis through screws, followed by thermal glue filling to further enhance heat dissipation. The present disclosure utilizes the simple modular connection of the front-end component, the two lateral linear flow channel components and the curved component to achieve the heat dissipation, the installation and the sealing without affecting the assembly of the inlet tube, the outlet tube, the bottom plate and the outer cover. For heat dissipation scenarios that need to adapt to different lengths and widths, the liquid cooling channel assembly of the present disclosure only requires size adjustments of certain structural components to achieve low-cost adaptation, thereby offering greater versatility.

## Claims

1. A liquid cooling channel assembly (1, 1a, 1b), **characterized by** comprising:
a front-end component (10) comprising an inlet (11), an outlet (12), and a connection side (13), wherein the inlet (11) and the outlet (12) are disposed at the connection side (13);
a curved component (20) having a first communication end (21) and a second communication end (22) opposite to each other;
a first lateral linear flow channel component (30, 30a) extended along a first direction and communicating between the inlet (11) and the first communication end (21); and
a second lateral linear flow channel component (40, 40a) extended along a second direction and communicating between the outlet (12) and the second communication end (22);
wherein the first lateral linear flow channel component (30, 30a) and the second lateral linear flow channel component (40, 40a) are spaced apart from each other to form two opposite inner heat dissipation surfaces (31, 41) and two opposite outer heat dissipation surfaces (32, 42);
wherein a first heat-generating device (91) is thermally connected to the two opposite inner heat dissipation surfaces (31, 41), and a second heat-generating device (92, 92a) is thermally connected to at least one of the two opposite outer heat dissipation surfaces (32, 42).

2. The liquid cooling channel assembly (1, 1a, 1b) according to claim 1, further comprising a bottom plate (50) disposed below the front-end component (10), the first lateral linear flow channel component (30, 30a), the second lateral linear flow channel component (40, 40a) and the curved component (20) to form an accommodation space (100) for accommodating the first heat-generating device (91), wherein the first heat-generating device (91) is further thermally connected to the front-end component (10), the curved component (20) and the bottom plate (50).

3. The liquid cooling channel assembly (1, 1a, 1b) according to claim 1, wherein the first heat-generating device (91) and the second heat-generating device (92, 92a) are disposed at a bottom surface (90) of a top PCB (9), the top PCB (9) is disposed above the front-end component (10), the first lateral linear flow channel component (30, 30a), the second lateral linear flow channel component (40, 40a) and the curved component (20), and the bottom surface (90) abuts against tops of the front-end component (10), the first lateral linear flow channel component (30, 30a), the second lateral linear flow channel component (40, 40a) and the curved component (20).

4. The liquid cooling channel assembly (1, 1a, 1b) according to claim 3, wherein the second heat-generating device (92) is disposed on a side PCB (921), the side PCB (921) is in contact with the outer heat dissipation surface (32, 42), and the side PCB (921) is disposed on the bottom surface (90) of the top PCB (9).

5. The liquid cooling channel assembly (1a) according to claim 3, wherein the second heat-generating device (92a) is a through-hole heat-generating device and is disposed at the bottom surface (90) of the top PCB (9), wherein the outer heat dissipation surface (32, 42) of the first lateral linear flow channel component (30) and/or the second lateral linear flow channel component (40) comprises a fixing pillar, a protrusion (36, 46) or a screw hole for fixing the second heat-generating device (92a).

6. The liquid cooling channel assembly (1, 1a, 1b) according to claim 1, wherein the first lateral linear flow channel component (30, 30a) has a first front end (301) and a first back end (302) opposite to each other, the first front end (301) is connected to the inlet (11), and the first back end (302) is connected to the first communication end (21); wherein the second lateral linear flow channel component (40, 40a) has a second front end (401) and a second back end (402) opposite to each other, the second front end (401) is connected to the outlet (12), and the second back end (402) is connected to the second communication end (22).

7. The liquid cooling channel assembly (1, 1a) according to claim 6, wherein the first lateral linear flow channel component (30) comprises a first lateral flow channel plate (33) and a first lateral cover plate (34), the first lateral flow channel plate (33) has a first groove (35) extended along the first direction, the first lateral cover plate (34) is connected to the first lateral flow channel plate (33) and covers the first groove (35) to form a first flattened internal chamber (300) communicating between the first front end (301) and the first back end (302); wherein the second lateral linear flow channel component (40) comprises a second lateral flow channel plate (43) and a second lateral cover plate (44), the second lateral flow channel plate (43) has a second groove (45) extended along the second direction, the second lateral cover plate (44) is connected to the second lateral flow channel plate (43) and covers the second groove (45) to form a second flattened internal chamber (400) communicating between the second front end (401) and the second back end (402), wherein the first lateral flow channel plate (33) and the first lateral cover plate (34), and the second lateral flow channel plate (43) and the second lateral cover plate (44), are fixedly connected through friction stir welding, laser welding, brazing, diffusion welding, electron beam welding or sealant bonding; and/or, the first lateral linear flow channel component (30) and the second lateral linear flow channel component (40) are respectively fixedly connected to the curved component (20) and/or the front-end component (10) through friction stir welding, laser welding, brazing, diffusion welding, electron beam welding or sealant bonding.

8. The liquid cooling channel assembly (1, 1a, 1b) according to claim 1, wherein the first lateral linear flow channel component (30, 30a) and the second lateral linear flow channel component (40, 40a) are constituted by extruded profile parts, stamping parts, die-casting parts or integrated parts.

9. The liquid cooling channel assembly (1, 1a, 1b) according to claim 1, wherein the curved component (20) and the front-end component (10) are constituted by die-casting parts, and have a structural strength thereof greater than or equal to a structural strength of the first lateral linear flow channel component (30, 30a) and the second lateral linear flow channel component (40, 40a).

10. The liquid cooling channel assembly (1, 1a, 1b) according to claim 1, wherein the inlet (11) and the outlet (12) are disposed at two opposite ends of the connection side (13), respectively, and the first communication end (21) and the second communication end (22) are spatially corresponding to the inlet (11) and the outlet (12), respectively.

11. The liquid cooling channel assembly (1, 1a, 1b) according to claim 1, wherein the front-end component (10) further comprises an inlet tube (15) and an outlet tube (16) disposed at a side (14) opposite to the connection side (13), the inlet tube (15) communicates to the inlet (11), and the outlet tube (16) communicates to the outlet (12), wherein a coolant enters from the inlet tube (15), flows through the inlet (11), the first lateral linear flow channel component (30, 30a), the curved component (20), the second lateral linear flow channel component (40, 40a) and the outlet (12), and is discharged through the outlet tube (16).

12. The liquid cooling channel assembly (1, 1a, 1b) according to claim 1, wherein the front-end component (10) further comprises an engagement portion (17), an inlet tube (15) and an outlet tube (16), the engagement portion (17) is disposed between the connection side (13), and the inlet tube (15) and the outlet tube (16), wherein when the liquid cooling channel assembly is assembled with a chassis (8), the engagement portion (17) is engaged with a sidewall (81) of the chassis (8), the first lateral linear flow channel component (30, 30a), the second lateral linear flow channel component (40, 40a) and the curved component (20) are accommodated in the chassis (8), and the inlet tube (15) and the outlet tube (16) are extended outwardly.

13. A power module (2, 2a, 2b), **characterized by** comprising:
a liquid cooling channel assembly (1, 1a, 1b), comprising a front-end component (10), a first lateral linear flow channel component (30, 30a), a second lateral linear flow channel component (40, 40a) and a curved component (20), wherein the front-end component (10) comprises an inlet (11), an outlet (12) and a connection side (13), the inlet (11) and the outlet (12) are disposed at the connection side (13), respectively, the curved component (20) has a first communication end (21) and a second communication end (22) opposite to each other, the first lateral linear flow channel component (30, 30a) is extended along a first horizontal direction and in communication between the inlet (11) and the first communication end (21), and the second lateral linear flow channel component (40, 40a) is extended along a second horizontal direction and in communication between the outlet (12) and the second communication end (22), wherein the first lateral linear flow channel component (30, 30a) and the second lateral linear flow channel component (40, 40a) are spaced apart from each other to form two opposite inner heat dissipation surfaces (31, 41) and two opposite outer heat dissipation surfaces (32, 42);
a first heat-generating device (91), disposed between the first lateral linear flow channel component (30, 30a) and the second lateral linear flow channel component (40, 40a), and thermally connected to the two opposite inner heat dissipation surfaces (31, 41); and
at least one second heat-generating device (92, 92a), disposed adjacent to the first lateral linear flow channel component (30, 30a) and/or the second lateral linear flow channel component (40, 40a) and/or the curved component (20), and correspondingly thermally connected to at least one of the two opposite outer heat dissipation surfaces (32, 42) and/or an outer heat dissipation surface (24) of the curved component (20).

14. The power module (2, 2a, 2b) according to claim 13, further comprising a top PCB (9) having a bottom surface (90), the bottom surface (90) abuts against tops of the front-end component (10), the first lateral linear flow channel component (30, 30a), the second lateral linear flow channel component (40, 40a) and the curved component (20), the first heat-generating device (91) and the at least one second heat-generating device (92, 92a) are disposed on the bottom surface (90), and the first lateral linear flow channel component (30, 30a) and/or the second lateral linear flow channel component (40, 40a) are located between the first heat-generating device (91) and the at least one second heat-generating device (92, 92a), respectively.

15. The power module (2, 2a, 2b) according to claim 13, further comprising a chassis (8) for fixing the liquid cooling channel assembly (1, 1a, 1b), wherein the front-end component (10) further comprises an inlet tube (15) and an outlet tube (16) disposed at a side (14) opposite to the connection side (13), the inlet tube (15) communicates to the inlet (11), and the outlet tube (16) communicates to the outlet (12), wherein a coolant enters from the inlet tube (15), flows through the inlet (11), the first lateral linear flow channel component (30, 30a), the curved component (20), the second lateral linear flow channel component (40, 40a) and the outlet (12), and is discharged through the outlet tube (16).
